# EUROPEAN PATENT APPLICATION

(11) **EP 4 769 375 A1**
(43) Date of publication of application: **01.07.2026**
(21) Application number: 25758706.3
(22) Date of filing: 19.02.2025
(51) Int. Cl.: G09G 3/32, H01L 25/075, H01L 25/16, H10H 29/14, H10H 20/857, H10H 20/01, G09G 3/20

(54) **DISPLAY DEVICE AND MANUFACTURING METHOD THEREFOR**

(30) Priority: 20.02.2024 KR 20240024204; 16.04.2024 KR 20240050608
(71) Applicant: Samsung Electronics Co., Ltd., Suwon-si, Gyeonggi-do 16677 (KR)
(72) Inventor: CHO, Seongphil, Suwon-si, Gyeonggi-do 16677 (KR); LEE, Hoseop, Suwon-si, Gyeonggi-do 16677 (KR); SEONG, Hwaseok, Suwon-si, Gyeonggi-do 16677 (KR); SHIGETA, Tetsuya, Suwon-si, Gyeonggi-do 16677 (KR)
(74) Representative: Gulde & Partner
(86) International application number: PCT/KR2025/099450
(87) International publication number: WO 2025/178457

(57) **Abstract**

A display device includes a glass substrate, a plurality of micro light emitting diodes (LEDs) disposed on a first surface of the glass substrate, a first drive part disposed on a second surface of the glass substrate and configured to drive the plurality of micro LEDs to emit light in a row-line order, and a second drive part disposed on the second surface of the glass substrate and configured to provide an image data signal through a data line coupled with one or more micro LEDs from among the plurality of micro LEDs. The plurality of micro LEDs are grouped into a plurality of groups based on a row line and each group of the plurality of groups is coupled with a different data line. The one or more micro LEDs belong to a same column line.

## Description

### [TECHNICAL FIELD]

The present disclosure relates generally to display devices, and more particularly, to a display device implementing a fine pitch display and a manufacturing method thereof.

### [BACKGROUND ART]

A micro light emitting diode (LED) may be and/or may include an ultra-small inorganic light-emitting material that may emit light by itself without a color filter and/or a backlight. For example, the micro LED may refer to an ultra-small LED having a length that may be shorter (smaller) that a length of a general LED chip (e.g., the length of the micro LED may be about a tenth (1/10) of the length of the general LED). As another example, an area of the micro LED may be smaller than an area of the general LED (e.g., the area of the micro LED may be about a hundredth (1/100) of the area of a general LED). As yet another example, a width, a length, and/or a height of the micro LED may be between 10 to 100 micrometers (µm).

The micro LEDs may implement various colors including white through red (R), green (G), blue (B) micro LEDs that may respectively express red, green, and blue colors.

If a display device is implemented using micro LEDs mounted on a printed circuit board (PCB), a pixel pitch may be relatively large, and as such, it may be difficult to produce a fine pitch display, as well as, potentially incurring in a relatively high material cost for producing the PCB.

### [DISCLOSURE]

### [TECHNICAL SOLUTION]

According to an aspect of the present disclosure, a display device includes a glass substrate, a plurality of micro light emitting diodes (LEDs) disposed on a first surface of the glass substrate, a first drive part disposed on a second surface of the glass substrate and configured to drive the plurality of micro LEDs to emit light in a row-line order, and a second drive part disposed on the second surface of the glass substrate and configured to provide an image data signal through a data line coupled with one or more micro LEDs from among the plurality of micro LEDs. The plurality of micro LEDs are grouped into a plurality of groups based on a row line and each group of the plurality of groups is coupled with a different data line. The one or more micro LEDs belong to a same column line.

According to an aspect of the present disclosure, a manufacturing method of a display device includes determining first positions of a plurality of micro LEDs disposed on a first surface of a glass substrate of the display device, determining second positions of a first drive part and a second drive part, disposed on a second surface of the glass substrate, implementing a scan line coupling the plurality of micro LEDs with the first drive part by using a plurality of metal wirings respectively formed on the first surface and the second surface of the glass substrate, and implementing a data line coupling the plurality of micro LEDs with the second drive part by using the plurality of metal wirings respectively formed on the first surface and the second surface of the glass substrate.

The implementing of the data line includes coupling the plurality of micro LEDs with the second drive part. The plurality of micro LEDs are grouped into a plurality of groups based on the scan line. Each group of the plurality of groups is coupled with a different data line.

Additional aspects may be set forth in part in the description which follows and, in part, may be apparent from the description, and/or may be learned by practice of the presented embodiments.

### [DESCRIPTION OF DRAWINGS]

The above and other aspects, features, and advantages of certain embodiments of the present disclosure may be more apparent from the following description taken in conjunction with the accompanying drawings, in which:
FIG. 1 is a block diagram showing a configuration of a display device, according to various embodiments of the present disclosure;
FIGS. 2 and 3 are diagrams showing a configuration of a drive part, according to the various embodiments of the present disclosure;
FIGS. 4 to 6 are diagrams illustrating a wiring structure of a data line, according to the various embodiments of the present disclosure;
FIG. 7 is a diagram illustrating a layer configuration of a glass substrate, according to the various embodiments of the present disclosure;
FIG. 8 is a diagram illustrating an operation of the drive part, according to the various embodiments of the present disclosure; and
FIGS. 9 to 11 are flowcharts illustrating a manufacturing method of a display device, according to the various embodiments of the present disclosure.

### [MODE FOR INVENTION]

The following description with reference to the accompanying drawings is provided to assist in a comprehensive understanding of embodiments of the present disclosure defined by the claims and their equivalents. Various specific details are included to assist in understanding, but these details are considered to be exemplary only. Therefore, those of ordinary skill in the art may recognize that various changes and modifications of the embodiments described herein may be made without departing from the scope and spirit of the disclosure. In addition, descriptions of well-known functions and structures are omitted for clarity and conciseness.

With regard to the description of the drawings, similar reference numerals may be used to refer to similar or related elements.

General terms currently widely used are selected as terms used in embodiments of the present disclosure in consideration of their functions in the present disclosure, and may be changed based on the intentions of those skilled in the art or a judicial precedent, the emergence of a new technique, or the like. In addition, in a specific case, terms arbitrarily chosen by an applicant may exist. Thus, the meanings of such terms may be mentioned in corresponding description portions of the present disclosure. Therefore, the terms used in the present disclosure are to be defined on the basis of the meanings of the terms and the contents throughout the present disclosure rather than simple names of the terms.

In the present disclosure, expressions such as, but not limited to, "have", "may have", "include", "may include", or the like may indicate the existence of a corresponding feature (e.g., a numerical value, a function, an operation, or a component such as a part), and may not exclude the existence of an additional feature.

In the present disclosure, an expression "A or B", "at least one of A and/or B", "one or more of A and/or B", or the like, may include all possible combinations of items enumerated together. For example, "A or B", "at least one of A and B" or "at least one of A or B" may indicate all of 1) a case where at least one A is included, 2) a case where at least one B is included, or 3) a case where both of at least one A and at least one B are included.

Expressions such as, but not limited to, "first", "second", or the like, used in the present disclosure may qualify various components regardless of a sequence or importance of the components. These expressions may be used only to distinguish one component and another component from each other, and may not limit the corresponding components.

If any component (e.g., a first component) is mentioned to be "(operatively or communicatively) coupled with/to" or "connected to" another component (e.g., a second component), it is to be understood that any component may be directly coupled to another component or may be coupled to another component through still another component (e.g., a third component).

It is to be understood that when an element or layer is referred to as being "over," "above," "on," "below," "under," "beneath," "connected to" or "coupled to" another element or layer, it may be directly over, above, on, below, under, beneath, connected or coupled to the other element or layer or intervening elements or layers may be present. In contrast, when an element is referred to as being "directly over," "directly above," "directly on," "directly below," "directly under," "directly beneath," "directly connected to" or "directly coupled to" another element or layer, there are no intervening elements or layers present.

As used herein, a term of a singular number may include its plural number unless explicitly interpreted otherwise in the context. It is to be understood that a term such as, but not limited to, "include", "formed of", or the like may be used in the present disclosure to indicate the presence of features, numerals, steps, operations, components, parts, or combinations thereof, mentioned in the specification, and may not preclude the presence or addition of one or more other features, numerals, steps, operations, components, parts, or combinations thereof.

In the present disclosure, a "module" or a "~er/~or" may perform at least one function or operation, and may be implemented by hardware, software, or a combination of hardware and software. In addition, a plurality of "modules" or a plurality of "~ers/~ors" may be integrated in at least one module to be implemented by at least one processor except for a "module" or a "~er/or" that needs to be implemented by specific hardware.

The terms "upper," "middle", "lower", and the like may be replaced with terms, such as "first," "second," third" to be used to describe relative positions of elements. The terms "first," "second," third" may be used to describe various elements but the elements are not limited by the terms and a "first element" may be referred to as a "second element". Alternatively or additionally, the terms "first", "second", "third", and the like may be used to distinguish components from each other and do not limit the present disclosure. For example, the terms "first", "second", "third", and the like may not necessarily involve an order or a numerical meaning of any form.

Reference throughout the present disclosure to "one embodiment," "an embodiment," "an example embodiment," or similar language may indicate that a particular feature, structure, or characteristic described in connection with the indicated embodiment is included in at least one embodiment of the present solution. Thus, the phrases "in one embodiment", "in an embodiment," "in an example embodiment," and similar language throughout this disclosure may, but do not necessarily, all refer to the same embodiment. The embodiments described herein are example embodiments, and thus, the disclosure is not limited thereto and may be realized in various other forms.

It is to be understood that the specific order or hierarchy of blocks in the processes/flowcharts disclosed are an illustration of exemplary approaches. Based upon design preferences, it is understood that the specific order or hierarchy of blocks in the processes/flowcharts may be rearranged. Further, some blocks may be combined or omitted. The accompanying claims present elements of the various blocks in a sample order, and are not meant to be limited to the specific order or hierarchy presented.

The embodiments herein may be described and illustrated in terms of blocks, as shown in the drawings, which carry out a described function or functions. These blocks, which may be referred to herein as units or modules or the like, or by names such as device, logic, circuit, controller, counter, comparator, generator, converter, or the like, may be physically implemented by analog and/or digital circuits including one or more of a logic gate, an integrated circuit, a microprocessor, a microcontroller, a memory circuit, a passive electronic component, an active electronic component, an optical component, and the like.

In the present disclosure, the articles "a" and "an" are intended to include one or more items, and may be used interchangeably with "one or more." Where only one item is intended, the term "one" or similar language is used. For example, the term "a processor" may refer to either a single processor or multiple processors. When a processor is described as carrying out an operation and the processor is referred to perform an additional operation, the multiple operations may be executed by either a single processor or any one or a combination of multiple processors.

Hereinafter, various embodiments of the present disclosure are described with reference to the accompanying drawings.

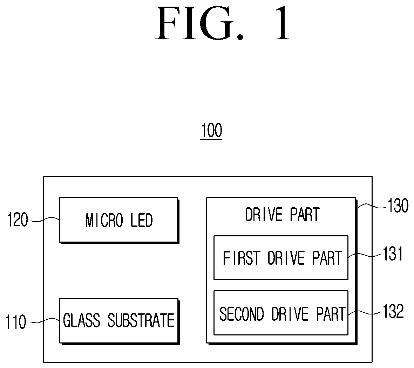

FIG. 1 is a block diagram showing a configuration of a display device, according to various embodiments of the present disclosure.

A display device 100 may be and/or may include a device that may display image content, such as, but not limited to, a television (TV), a desktop personal computer (PC), a laptop, a video wall, a large format display (LFD), a digital signage, a digital information display (DID), a projector display, a digital video disk (DVD) player, a smartphone, a tablet PC, a monitor, smart glasses, a smart watch, or the like, and may use any device capable of displaying an input image.

The display device 100 may include an array of pixels arranged in a matrix form. The pixel array may include a plurality of row lines and/or a plurality of column lines. In some embodiments, the row line may be referred to as a horizontal line, and the column line may be referred to as a vertical line. The terms such as, but not limited to, the row line, the horizontal line, the column line, and the vertical line may be used as terms that may refer to lines formed by the pixels in the pixel array.

In addition, terms such as, but not limited to, a scan line or a data line may be used as a term that may refer to a wiring for transmitting data and/or a signal to each pixel. The scan line may be connected to the pixels belonging to the row line of the pixel array and may provide the scan signal to each pixel. The data line may be connected to the pixels belonging to the column line of the pixel array and provide the image data signal to each pixel.

Each pixel in the pixel array may include three (3) sub-pixels (e.g., red (R), green (G), and blue (B) sub-pixels). For example, a single pixel may include three (3) types of sub-pixels such as a red color sub-pixel for expressing red, a green color sub-pixel for expressing green, and a blue color sub-pixel for expressing blue. However, the present disclosure is not limited in this regard. For example, the pixel may include a different number of sub-pixels (e.g., four (4) or more) and/or may include different color sub-pixels (e.g., a white sub-pixel).

In the display device 100, according to the various embodiments of the present disclosure, each sub-pixel may be implemented as a micro light emitting diode (LED). The micro LED may be manufactured to have an ultra-small size of less than 100 micrometers (µm), for example, and may be used to implement a ultra-high resolution when applied to TVs of various sizes and/or small wearable devices (e.g., a smart watch). Hereinafter, the sub-pixel and the micro LED may be described as the same component.

Referring to FIG. 1, the display device 100 may include a glass substrate 110, a plurality of micro LEDs 120, and a drive part 130. However, the display device 100 is not limited thereto, and may be implemented to exclude some configurations therefrom, or may be implemented to further include another configuration.

The plurality of micro LEDs 120 may be arranged on one surface of the glass substrate 110. For example, the plurality of micro LEDs 120 may be arranged in the matrix form including the plurality of row lines and/or the plurality of column lines.

The drive part 130 may be disposed on the other surface of the glass substrate 110 and may include a first drive part 131 and a second drive part 132. The first drive part 131 may drive the micro LEDs 120 for the plurality of micro LEDs 120 to emit light in a row-line order. The second drive part 132 may provide the image data signal through the data line connected to the plurality of micro LEDs 120.

For example, the first drive part 131 may be disposed on the glass substrate 110 in a horizontal direction, and provide the scan signal to each scan line electrically connected to the plurality of micro LEDs 120. The second drive part 132 may be disposed on the glass substrate 110 in a vertical direction, and provide the image data signal through the data line electrically connected to the plurality of micro LEDs 120.

In an embodiment, the plurality of micro LEDs 120 may be grouped into a plurality of groups based on the row lines, and each group may be connected to a different data line. For example, if the plurality of micro LEDs 120 are arranged in 240 column lines and 270 row lines, the plurality of micro LEDs 120 may be grouped into three (3) groups by grouping 90 row lines into each group. That is, the plurality of micro LEDs 120 may be grouped into a first group from the first to 90th row lines of the 270 row lines, a second group from the 91st to 180th row lines thereof, and a third group from the 181st to 270th row lines thereof. As another example, the plurality of micro LEDs 120 may be grouped into two (2) groups including a first group from the first to 135th row lines, and a second group from the 136th to 270th row lines. However, the plurality of micro LEDs 120 is not limited thereto, and may be grouped into various groups in consideration of a load of the drive part 130 and/or a wiring formed in the glass substrate 110. For example, the plurality of micro LEDs 120 may arranged into different numbers of columns and/or row lines, may be grouped into more groups (e.g., four (4) or more), and/or the groups may contain different numbers of rows from each other.

In addition, the plurality of micro LEDs 120 may be connected to the different data lines for each group based on the column line. For example, a total number of data lines connected to the plurality of micro LEDs 120 may be 720 if the plurality of micro LEDs 120 are arranged in 240 column lines and 270 row lines, and the 270 row lines may be grouped into three (3) groups. However, the present disclosure is not limited in this regard.

The second drive part 132 may provide the same image data signal to the data line connected to the micro LEDs 120 belonging to the same column line from among the plurality of micro LEDs 120. For example, the second drive part 132 may provide the image data signal to the plurality of micro LEDs 120 through 720 channels if the plurality of micro LEDs 120 are grouped into three (3) groups to form 720 data lines. Among the plurality of micro LEDs 120, the first group of the first column line may be connected to the first channel of the second drive part 132 through the first data line, the second group of the first column line may be connected to the second channel of the second drive part 132 through the second data line, and the third group of the first column line may be connected to the third channel of the second drive part 132 through the third data line. That is, the second drive part 132 may provide the same image data signal to the micro LEDs 120 belonging to the first column line from among the plurality of micro LEDs 120 through the first channel, the second channel, and the third channel.

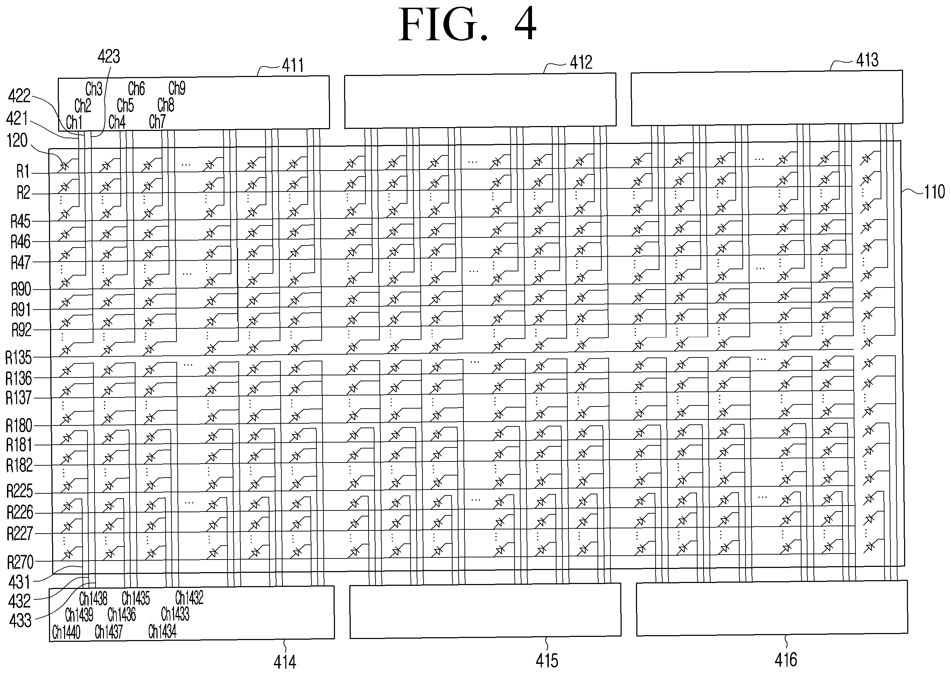

An operation of grouping the plurality of micro LEDs 120 into the plurality of groups and connecting the micro LED to the data line is described with reference to FIG. 4.

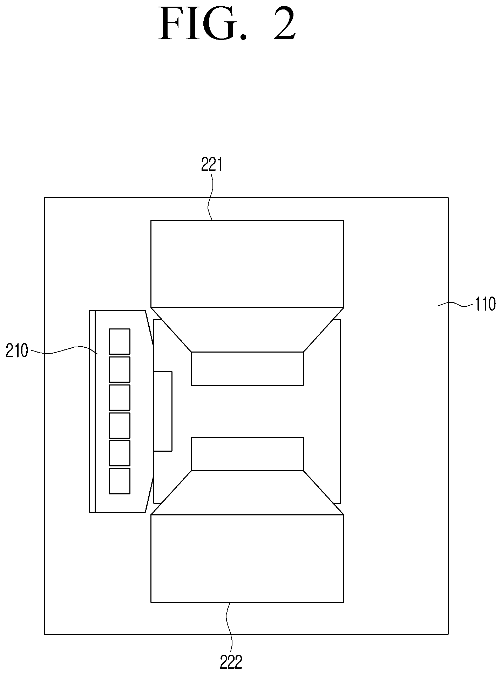

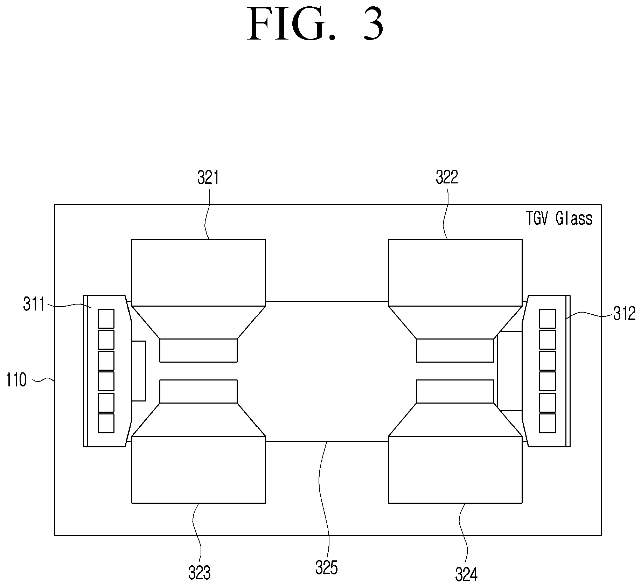

FIGS. 2 and 3 are diagrams showing a configuration of the drive part, according to the various embodiments of the present disclosure. FIGS. 2 and 3 show configurations of the first drive part and the second drive part, disposed on the other surface of the glass substrate 110. For example, FIG. 2 shows configurations of a first drive part 210 and a plurality of second drive parts (e.g., an upper second drive part 221 and a lower second drive part 222), disposed on the other surface of the glass substrate 110. The first drive part 210 and the plurality of second drive parts 221 and 222 of FIG. 2 may include and/or may be similar in many respects to the first drive part 131 and the second drive part 132 described above with reference to FIG. 1, respectively, and may include additional features not mentioned above. Consequently, repeated descriptions of the first drive part 210 and the plurality of second drive parts described above with reference to FIG. 1 may be omitted for the sake of brevity.

In an embodiment, the display device 100 may be implemented to have a resolution of 120×160. At the resolution of 120×160, 120 may represent the number of column lines configured for the plurality of micro LEDs 120 arranged on one surface of the glass substrate 110, and 160 may represent the number of row lines configured for the plurality of micro LEDs 120. However, the present disclosure is not limited in this regard, and the display device 100 may be implemented to have various other resolutions and/or may be configured to have various other numbers of column lines and/or row lines.

Referring to FIG. 2, the first drive part 210 may be disposed on the glass substrate 110 in the horizontal direction, and the upper and lower second drive parts 221 and 222 may be disposed on the glass substrate 110 in the vertical direction. The first drive part 210 may be electrically connected to the plurality of micro LEDs 120 arranged on one surface of the glass substrate 110, and may provide the scan signal to the plurality of micro LEDs 120 in the row-line order. For example, if 160 row lines are configured for the plurality of micro LEDs 120, the first drive part 210 may sequentially provide the scan signal starting from the plurality of micro LEDs 120 included in the first row line to those included in the 160th row line.

As shown in FIG. 2, the upper second drive part 221 may be disposed on an upper part of the glass substrate 110, and the lower second drive part 222 may be disposed on a lower part of the glass substrate 110. For example, if the 160 row lines are configured for the plurality of micro LEDs 120, 80 row lines arranged on the upper part may be electrically connected to the upper second drive part 221, and 80 row lines arranged on the lower part may be electrically connected to the upper second drive part 222. In an embodiment, the wiring formed on one surface of the glass substrate 110 and the wiring formed on the other surface thereof for connecting the plurality of micro LEDs 120 with the first drive part 210 and the upper and lower second drive parts 221 and 222 may be connected to each other through a through-glass via (TGV) passing through the glass substrate 110.

FIG. 3 shows the configurations of the first drive parts and the second drive parts, disposed on the other surface of the glass substrate 110, where the display device 100 is implemented to have a resolution of 240×160, which may be higher than the resolution of the display device shown in FIG. 2. At the resolution of 240×160, 240 may represent the number of column lines configured for the plurality of micro LEDs 120 arranged on one surface of the glass substrate 110, and 160 may represent the number of row lines configured for the plurality of micro LEDs 120.

Referring to FIG. 3, first drive parts (e.g., a left first drive part 311 and a right first drive part 312) may be disposed on the glass substrate 110 in the horizontal direction, and a plurality of second drive parts (e.g., an upper left second drive part 321, an upper right drive part 322, a lower left drive part 323, and a lower right drive part 324) may be disposed on the glass substrate 110 in the vertical direction. The left and right first drive parts 311 and 312 and the plurality of second drive parts 321 to 324 of FIG. 3 may include and/or may be similar in many respects to the first drive parts 131 and 210 and the second drive parts 132, 221, and 222 described above with reference to FIGS. 1 and 2, respectively, and may include additional features not mentioned above. Consequently, repeated descriptions of the left and right first drive parts 311 and 312 and the plurality of second drive parts 321 to 324 described above with reference to FIGS. 1 and 2 may be omitted for the sake of brevity.

In an embodiment, the left first drive part 311 may be electrically connected to the micro LEDs 120 in the first to 120th column lines from among the plurality of micro LEDs 120 arranged on one surface of the glass substrate 110. The right first drive part 312 may be electrically connected to the micro LEDs 120 in the 121st to 240th column lines from among the plurality of micro LEDs 120. In addition, the left and right first drive parts 311 and 312 may sequentially provide the scan signal from the first to 160th row lines of the plurality of micro LEDs 120.

As shown in FIG. 3, the left and right upper second drive parts 321 and 322 may be disposed on the upper part of the glass substrate 110, and the left and right lower second drive parts 323 and 324 may be disposed on the lower part of the glass substrate 110. For example, if the plurality of micro LEDs 120 are arranged at the resolution of 240×160, the plurality of micro LEDs 120 may be arranged in the first to 80th row lines and in the first to 120th column lines may be electrically connected to the left upper second drive part 321. Among the plurality of micro LEDs 120, the plurality of micro LEDs 120 arranged in the first to 80th row lines and in the 121st to 240th column lines may be electrically connected to the right upper second drive part 322. Among the plurality of micro LEDs 120, the plurality of micro LEDs 120 arranged in the 81st to 160th row lines and in the first to 120th column lines may be electrically connected to the left lower second drive part 323. Among the plurality of micro LEDs 120, the plurality of micro LEDs 120 arranged in the 81st to 160th row lines and in the 121st to 240th column lines may be electrically connected to the right lower second drive part 324.

In an embodiment, wirings for connecting the plurality of micro LEDs 120 with the left and right first drive parts 311 and 312 and the upper and lower second drive parts 321 to 324 may be connected to each other through the TGV passing through the glass substrate 110.

In such a manner, the display device 100, according to the present disclosure, may implement a bezel-less display by arranging the plurality of micro LEDs 120 on one surface of the glass substrate 110, disposing the drive part on the other surface of the glass substrate 110, and connecting the wiring formed on one surface and the wiring formed on the other surface to each other through the TGV passing through the glass substrate 110. In addition, the wiring may be formed on one surface and the other surface of the glass substrate 110, thereby forming the plurality of wirings without using high-level layers.

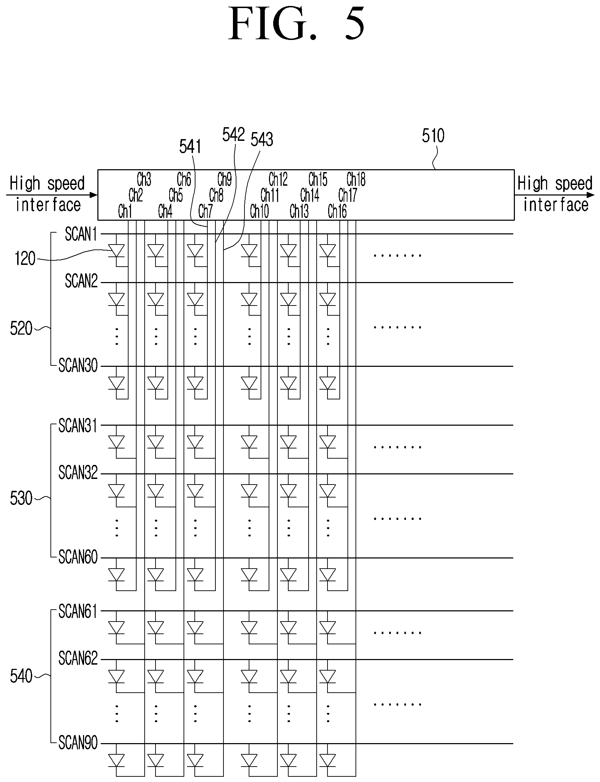

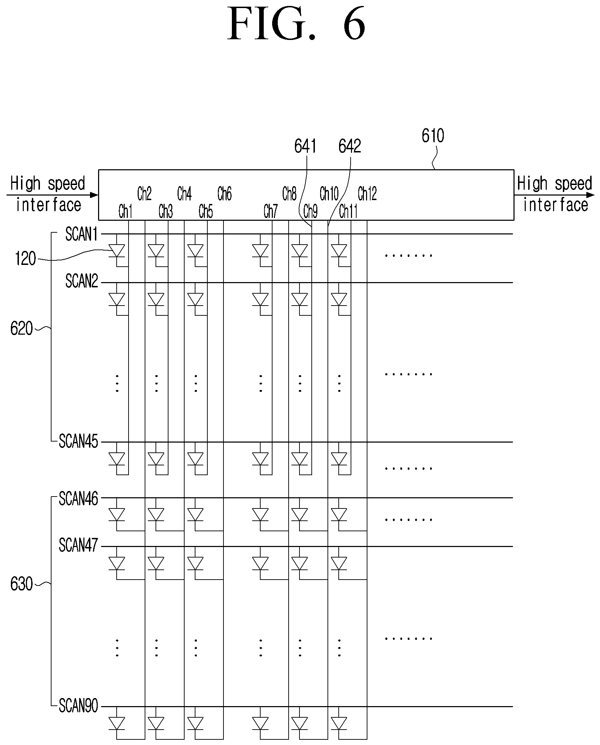

FIGS. 4 to 6 are diagrams illustrating a wiring structure of the data line, according to the various embodiments of the present disclosure. For example, FIG. 4 shows the display device 100 having a resolution of 480×270. At the resolution of 480×270, 480 may represent the number of column lines configured for the plurality of micro LEDs 480 arranged on one surface of the glass substrate 110, and 270 may represent the number of row lines configured for the plurality of micro LEDs 120. In addition, FIGS. 5 and 6 may be diagrams showing the data lines for grouping the plurality of micro LEDs 120 and connecting the micro LEDs to the second drive part for each group, according to the various embodiments of the present disclosure.

As described above with reference to FIG. 1, the plurality of micro LEDs 120 may be arranged on one surface of the glass substrate 110, and the drive part may be disposed on the other surface of the glass substrate 110. For example, if the plurality of micro LEDs 120 are arranged on the upper surface of the glass substrate, the drive part may be disposed on the lower surface of the glass substrate 110. However, for convenience of description, FIG. 4 shows that the plurality of micro LEDs 120 and a plurality of second drive parts (e.g., an upper left second drive part 411, an upper middle second drive part 412, an upper right second drive part 413, a lower left second drive part 414, a lower middle second drive part 415, and a lower right second drive part 416) may be disposed on the same plane. The plurality of second drive parts 411 to 416 of FIG. 4 may include and/or may be similar in many respects to the second drive parts 132, 221, 222, and 321 to 324 described above with reference to FIGS. 1 to 3, and may include additional features not mentioned above. Consequently, repeated descriptions of the plurality of second drive parts 411 to 416 described above with reference to FIGS. 1 to 3 may be omitted for the sake of brevity. In addition, FIG. 4 may omit illustrating the first drive part for convenience of description.

Referring to FIG. 4, the plurality of second drive parts 411 to 416 may be disposed on the glass substrate 110 in the vertical direction. The upper second drive parts 411 to 413 may be disposed on the upper part of the glass substrate 110, and the lower second drive parts 414 to 416 may be disposed on the lower part of the glass substrate 110, respectively.

For example, 270 row lines may be configured for the plurality of micro LEDs 120 arranged on one surface of the glass substrate 110 if the display device 100 is implemented to have the resolution of 480×270. The first drive part may sequentially provide the scan signal for each row line starting from a first row line R1 to a 270th row line R270 of the plurality of micro LEDs 120.

In an embodiment, the plurality of second drive parts 411 to 416 may be connected to the micro LEDs 120 respectively belonging to 135 row lines from among the plurality of micro LEDs 120. For example, the upper second drive parts 411 to 413 disposed on the upper part of the glass substrate 110 may be connected to the micro LEDs 120 belonging to the first row line R1 to the 135th row line R135 from among the plurality of micro LEDs 120. The lower second drive parts 414 to 416 disposed on the lower part of the glass substrate 110 may be connected to the micro LEDs 120 belonging to the 136th row line R136 to the 270th row line R270 from among the plurality of micro LEDs 120. That is, the 270 row lines may be grouped into two (2) groups having 135 row lines each, and the upper second drive parts 411 to 413 may be connected to one group and the lower second drive parts 414 to 416 may be connected to the other group. However, the present disclosure is not limited in this regard, and the display device 100 may have various other numbers of row lines that may be grouped into various other numbers of groups (e.g., three (3) or more) and/or the each groups may have the same or different numbers of row lines.

In addition, the micro LEDs 120 belonging to the first row line R1 to the 45th row line R45 from among the plurality of micro LEDs 120 may be grouped into a first upper group and be respectively connected to the upper second drive parts 411 to 413. Among the plurality of micro LEDs 120, the micro LEDs 120 belonging to the 46th row line R46 to the 90th row line R90 may be grouped into a second upper group and be respectively connected to the upper second drive parts 411 to 413, and the micro LEDs 120 belonging to the 91st row line R91 to the 135th row line R135 may be grouped into a third upper third group, and be respectively connected to the upper second drive parts 411 to 413.

In addition, the micro LED 120 belonging to the 136th row line R136 to the 180th row line R180 from among the plurality of micro LEDs 120 may be grouped into a first lower group and be respectively connected to the lower second drive parts 414 to 416. The micro LEDs 120 belonging to the 181st row line R181 to the 225th row line R225 from among the plurality of micro LEDs 120 may be grouped into a second lower group and be respectively connected to the lower second drive parts 414 to 416, and the micro LEDs 120 belonging to the 226th row line R226 to the 270th row line R270 of the plurality of micro LEDs 120 may be grouped into a third lower third group and be respectively connected to the lower second drive parts 414 to 416.

The same image data signal may be provided to the data lines connected to the micro LEDs 120 belonging to the same column line from among the plurality of micro LEDs 120. For example, as shown in FIG. 4, the same image data signal may be provided to a first data line 421 connected to the first channel Ch1 of the upper left second drive part 411, a second data line 422 connected to the second channel Ch2 thereof, a third data line 423 connected to the third channel Ch3 thereof, a 1440th data line 431 connected to a 1440th channel Ch1440 of the lower left second drive part 414, a 1439th data line 432 connected to a 1439th channel Ch1439 thereof, and a 1438th data line 433 connected to a 1438th channel Ch1438 thereof.

FIG. 5 is a diagram illustrating the plurality of micro LEDs 120 connected to a second drive part 510. That is, FIG. 5 is a diagram illustrating the wiring structure of the data line if the plurality of micro LEDs 120 are grouped into three (3) groups, for example. The second drive part 510 of FIG. 5 may include and/or may be similar in many respects to the second drive parts 132, 221, 222, 321 to 324, and 411 to 416 described above with reference to FIGS. 1 to 4, and may include additional features not mentioned above. Consequently, repeated descriptions of the second drive part 510 described above with reference to FIGS. 1 to 4 may be omitted for the sake of brevity.

Referring to FIG. 5, the plurality of micro LEDs 120 arranged on the glass substrate 110 may be grouped into the three (3) groups. For example, if the plurality of micro LEDs 120 are arranged in 90 row lines, the micro LEDs may be grouped into the three (3) groups, each being classified by 30 row lines. A first group 520 may include the micro LEDs 120 belonging to a first row line SCAN1 to a 30th row line SCAN30 from among the plurality of micro LEDs 120. A second group 530 may include the micro LED 120 belonging to a 31st row line SCAN31 to a 60th row line SCAN60 from among the plurality of micro LEDs 120. A third group 540 may include the micro LED 120 belonging to a 61st row line SCAN61 to a 90th row line SCAN90 from among the plurality of micro LEDs 120. In addition, the second drive part 510 may form different data lines for each group to provide the image data signals to the plurality of micro LEDs 120.

As shown in FIG. 5, the micro LED 120 belonging to the first column line may be implemented as the red color sub-pixel (R sub-pixel), the micro LED 120 belonging to the second column line may be implemented as the green color sub-pixel (G sub-pixel), and the micro LED 120 belonging to the third column line may be implemented as the blue color sub-pixel (B sub-pixel). The same order may then be repeated in the vertical direction.

Consequently, the image data signal provided to the data line may be applied in an order of RRRGGGBBB when examining each pixel signal based on the data line to which the image data signal is provided from the second drive part 510. However, the present disclosure is not limited in this regard, and the image data signal may be applied in various other orders based on the configuration and/or arrangement of sub-pixels in the plurality of micro LEDs 120.

The first drive part may sequentially drive the plurality of micro LEDs 120 from the first row line SCAN1 to the last row line SCAN90 for the micro LEDs to emit light in the row-line order. The second drive part 510 may provide the image data signal to each column line of the plurality of micro LEDs 120. For example, the second drive part 510 may provide the image data signal corresponding to the first row line SCAN1 to each column line of the plurality of micro LEDs 120 if the first drive part applies a drive voltage to the first row line SCAN1 to cause the first row line SCAN1 to emit light. In the first row line SCAN1 of the plurality of micro LEDs 120, the B sub-pixel belonging to the third column line may emit light if the second drive part 510 provides the image data signal to the third column line.

In an embodiment, the second drive part 510 may provide the same image data signal to a data line 541 connected to the 7th channel Ch7, a data line 542 connected to the 8th channel Ch8, and a data line 543 connected to the 9th channel Ch9.

FIG. 6 is a diagram illustrating the wiring structure of the data line if the plurality of micro LEDs 120 are grouped into two (2) groups.

Referring to FIG. 6, the plurality of micro LEDs 120 arranged on the glass substrate 110 may be grouped into the two (2) groups. For example, if the plurality of micro LEDs 120 are arranged in 90 row lines, the micro LEDs may be grouped into the two (2) groups, each being classified by 45 row lines. A first group 620 may include the micro LEDs 120 belonging to the first row line SCAN1 to a 45th row line SCAN45 from among the plurality of micro LEDs 120. A second group 630 may include the micro LED 120 belonging to a 46th row line SCAN46 to the 90th row line SCAN90 from among the plurality of micro LEDs 120.

As shown in FIG. 6, the micro LED 120 belonging to the first column line may be implemented as the R sub-pixel, the micro LED 120 belonging to the second column line may be implemented as the G sub-pixel, and the micro LED 120 belonging to the third column line may be implemented as the B sub-pixel. The same order may then be repeated in the vertical direction. Consequently, the image data signal may be provided to the data line is applied in an order of RRGGBB when examining each pixel signal based on the data line to which the image data signal is provided from the second drive part 610.

As in FIG. 5, the second drive part 610 may provide the image data signal to each column line of the plurality of micro LEDs 120. The second drive part 610 of FIG. 6 may include and/or may be similar in many respects to the second drive parts 132, 221, 222, 321 to 324, 411 to 416, and 510 described above with reference to FIGS. 1 to 5, and may include additional features not mentioned above. Consequently, repeated descriptions of the second drive part 610 described above with reference to FIGS. 1 to 5 may be omitted for the sake of brevity.

For example, the second drive part 610 may provide the image data signal corresponding to the second row line SCAN2 to each column line of the plurality of micro LEDs 120 if the first drive part applies the drive voltage to the second row line SCAN2 to cause the second row line SCAN2 to emit light. In the second row line SCAN2 of the plurality of micro LEDs 120, the G sub-pixel belonging to the fifth column line may emit light if the second drive part 610 provides the image data signal to the fifth column line. In an embodiment, the second drive part 610 may provide the same image data signal to a data line 641 connected to the 9th channel Ch9, and a data line 642 connected to the 10th channel Ch10.

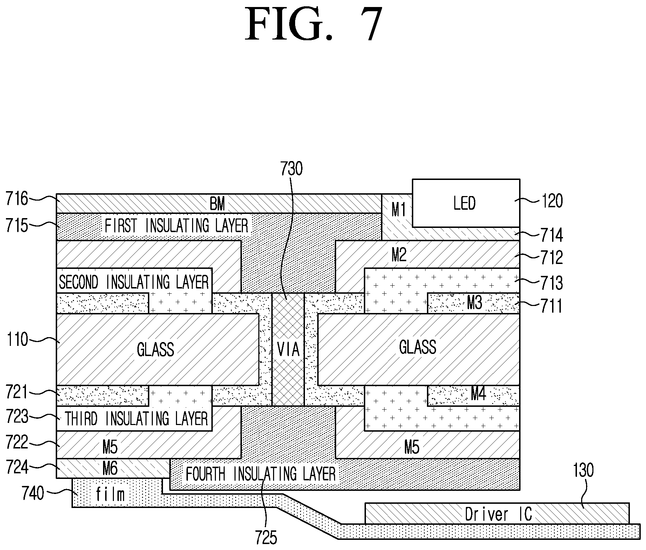

FIG. 7 is a diagram illustrating a layer configuration of the glass substrate, according to the various embodiments of the present disclosure. FIG. 7 shows each configuration shown in FIG. 1 and a wiring layer structure for connecting the respective configurations to each other. Referring to FIG. 7, the display device 100 is described based on an embodiment where the display device is implemented using a passive matrix (PM) driving method. However, the present disclosure is not limited in this regard, and the display device may be implemented using various other methods without departing from the scope of the present disclosure. The glass substrate may further include a layer for implementing a thin film transistor (TFT) if the display device 100 is implemented using an active matrix (AM) driving method.

Referring to FIG. 7, a third metal wiring 711 may be formed on one surface of the glass substrate 110 to electrically connect the drive part 130 with the micro LED 120. The third metal wiring 711 may be formed to transmit the scan signal provided from the first drive part 131 to the micro LED 120. The fourth metal wiring 721 may be formed on the other surface of the glass substrate 110 to electrically connect the first drive part 131 with the micro LED 120. The fourth metal wiring 721 may be formed to transmit the scan signal provided from the first drive part 131 to the micro LED 120. That is, the third metal wiring 711 and the fourth metal wiring 721 may form the scan line for electrically connecting the first drive part 131 with the plurality of micro LEDs 120. In an embodiment, the third metal wiring 711 formed on one surface of the glass substrate 110 and the fourth metal wiring 721 formed on the other surface of the glass substrate 110 may be connected to each other using a TGV 730 passing through the glass substrate 110.

In addition, referring to FIG. 7, a second metal wiring 712 may be formed on one surface of the glass substrate 110 to electrically connect the drive part 130 with the micro LED 120. The second metal wiring 712 may be formed to transmit the image data signal provided from the second drive part 132 to the micro LED 120. The second metal wiring 712 may be implemented as a structure stacked above a layer that configures the third metal wiring 711. In an embodiment, a second insulating layer 713 may be formed between the third metal wiring 711 and the second metal wiring 712 to insulate the third metal wiring 711 and the second metal wiring 712 from each other.

The fifth metal wiring 722 may be formed on the other surface of the glass substrate 110 to electrically connect the drive part 130 with the micro LED 120. The fifth metal wiring 722 may be formed to transmit the image data signal provided from the second drive part 132 to the micro LED 120. That is, the second metal wiring 712 and the fifth metal wiring 722 may form the data line for electrically connecting the second drive part 132 with the plurality of micro LEDs 120. The fifth metal wiring 722 may be implemented as a structure stacked above a layer that configures the fourth metal wiring 721.

In an embodiment, a third insulating layer 723 may be formed between the fourth metal wiring 721 and the fifth metal wiring 722 to insulate the fourth metal wiring 721 and the fifth metal wiring 722 from each other. In addition, the second metal wiring 712 formed on one surface of the glass substrate 110 and the fifth metal wiring 722 formed on the other surface of the glass substrate 110 may be connected to each other using the TGV 730 passing through the glass substrate 110.

A plurality of first connection pads and third connection pads, electrically connected to the micro LED 120, may be formed on one surface of the glass substrate 110. The first connection pads may be implemented to respectively electrically connect the micro LED 120 with the second metal wiring 712. The third connection pads may be implemented to respectively electrically connect the micro LED 120 with the third metal wiring 711. The first connection pad or the third connection pad may be implemented using a first metal layer 714. In addition, the first metal layer 714 may be implemented as a structure stacked above a layer configuring the second metal wiring 712. In an embodiment, a first insulating layer 715 may be formed between the first metal layer 714 and the second metal wiring 712 to insulate the first metal layer 714 and the second metal wiring 712 from each other.

The first metal layer 714 and the second metal wiring 712 may be connected to each other by using a via that passes through the first insulating layer 715 when connecting the first metal layer 714 with the second metal wiring 712 to form a wiring path between the micro LED 120 and the second metal wiring 712.

In addition, the first metal layer 714 and the third metal wiring 711 may be connected to each other by using a via that passes through the first insulating layer 715 and the second insulating layer 713 when connecting the first metal layer 714 with the third metal wiring 711 to form a wiring path between the micro LED 120 and the third metal wiring 711. In an embodiment, a second metal pattern may be formed between the first insulating layer 715 and the second insulating layer 713 to facilitate the connection between the first metal layer 714 and the third metal wiring 711.

A plurality of second connection pads and fourth connection pads, electrically connected to the drive part 130, may be formed on the other surface of the glass substrate 110. The second connection pads may be implemented to respectively electrically connect the second drive part 132 with the fifth metal wiring 722. The fourth connection pads may be implemented to respectively electrically connect the first drive part 131 with the fourth metal wiring 721. The second connection pad or the fourth connection pad may be implemented using a sixth metal layer 724. In addition, the sixth metal layer 724 may be implemented as a structure stacked on a layer configuring the fifth metal wiring 722. In an embodiment, a fourth insulating layer 725 may be formed between the sixth metal layer 724 and the fifth metal wiring 722 to insulate the sixth metal layer 724 and the fifth metal wiring 722 from each other.

The sixth metal layer 724 and the fifth metal wiring 722 may be connected to each other by using a via that passes through the fourth insulating layer 725 when connecting sixth metal layer 724 and the fifth metal wiring 722 to form a wiring path between the drive part 130 and the fifth metal wiring 722.

In addition, the sixth metal layer 724 and the fourth metal wiring 721 may be connected to each other by using a via that passes through the third insulating layer 723 and the fourth insulating layer 725 when connecting the sixth metal layer 724 with the fourth metal wiring 721 to form a wiring path between the drive part 130 and the fourth metal wiring 721. In an embodiment, a fifth metal pattern may be formed between the third insulating layer 723 and the fourth insulating layer 725 to facilitate the connection between the sixth metal layer 724 and the fourth metal wiring 721.

A black matrix (BM) 716 may be formed on one surface of the glass substrate 110. For example, the BM 716 may be implemented as a structure stacked on the first insulating layer 715 or the first metal layer 714.

The BM 716 may refer to a black region that separates the red, green, blue (RGB) sub-pixels in the display from one another. The BM 716 may be formed before arranging the micro LEDs for the RGB sub-pixels to thus function as a partition to separate each sub-pixel region. In addition, the BM 716 may function to prevent light leakage of LED backlight, prevent color mixing of the RGB sub-pixels, and/or prevent an increase in a leakage current of the thin film transistor (TFT) due to an external light source. The BM 716 may be manufactured through a photolithography process performed on the glass substrate before arranging the micro LEDs. If the BM 716 is manufactured, the micro LEDs for the RGB sub-pixels may be arranged between the manufactured BMs 716.

The plurality of second connection pads and the plurality of fourth connection pads may be electrically connected to the drive part 130 through a film on glass (FOG) wiring. A FOG method may refer to a technology for bonding glass and a flexible circuit board to each other at a specific temperature, pressure, and/or time to simultaneously (e.g., during a substantially similar time period) implement their mechanical connection and electrical conductivity. The drive part 130 may be electrically connected to the second connection pad and the fourth connection pad through the wiring implemented as a film.

Although FIG. 7 shows that the second metal wiring 712 or the fifth metal wiring 722 is used as the wiring for implementing the data line, and the third metal wiring 711 or the fourth metal wiring 721 is used as the wiring for implementing the scan line, the wiring is not limited thereto, and may be implemented using any of various stack orders and/or wiring structures. For example, the second metal wiring 712 or the fifth metal wiring 722 may be used as the wiring for implementing the scan line, and the third metal wiring 711 or the fourth metal wiring 721 may be used as the wiring for implementing the data line.

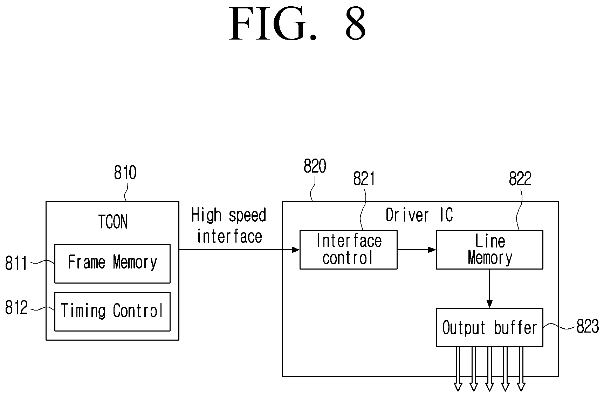

FIG. 8 is a diagram illustrating an operation of the drive part, according to the various embodiments of the present disclosure.

If the display device 100 is implemented using the passive matrix (PM) driving method, the display device 100 may drive and display image data information in a sub-frame unit. For example, the drive part 820 may directly control the image data information in the sub-frame unit if a timing controller provides the image data information to the drive part 820 in a frame unit. In such an example, if a frame memory is included in the drive part 820, a substantial amount of power may be consumed and/or heat may be generated in the drive part 820 in a process of converting the image data information in the frame unit that is stored in the frame memory into the image data information in the sub-frame unit. In addition, excessive heat generated by the drive part 820 may potentially impede the display device 100 from implementing a high-brightness display.

In the display device 100, according to the various embodiments of the present disclosure, a timing controller 810 may directly process (control) the sub-frame unit driving of the image data information, thereby potentially reducing the load of the drive part 820 and/or reducing heat occurring in the drive part 820, when compared to related display devices.

Referring to FIG. 8, the display device 100 may further include the timing controller 810 for providing the scan signal and the image data signal to a drive part (driver integrated circuit (IC)) 820 for the plurality of micro LEDs 120 to emit light in the row-line order based on the image data signal. The timing controller 810 may include a frame memory 811 and a timing control part 812.

The frame memory 811 may be and/or may include a component for storing the image data information input to the display device 100. The frame memory 811 may be implemented in the form of a memory embedded in the timing controller 810. For example, the frame memory 811 may be implemented as at least one of a volatile memory (e.g., a dynamic random access memory (DRAM), a static RAM (SRAM), or a synchronous dynamic RAM (SDRAM)), a non-volatile memory (e.g., an one time programmable read only memory (OTPROM), a programmable ROM (PROM), an erasable and programmable ROM (EPROM), an electrically erasable and programmable ROM (EEPROM), a mask ROM, or a flash ROM), a flash memory (e.g., a NAND flash or a NOR flash), a hard drive, a solid state drive (SSD)), or the like.

The timing control part 812 may convert the image data information in the frame unit that is stored in the frame memory 811 into the image data information in the sub-frame unit and output the converted image data information in the sub-frame unit. For example, the timing control part 812 may compare the image data information in the frame unit that is stored in the frame memory 811 based on a predetermined condition and convert the same into the image data information in the sub-frame unit.

The drive part 820 may include an interface 821, a line memory 822, and an output buffer 823. The interface 821 may be a component for receiving the image data information in the sub-frame unit that is provided from the timing control part 812. The interface 821 may be implemented as an interface operated at a relatively high speed. For example, the interface 821 may receive the image data information in the sub-frame unit from the timing control part 812 at a transmission rate of several gigabits per second (Gbps).

If the frame memory is included in the drive part 820, the drive part 820 may receive the image data information in the frame unit from the timing controller, and thus receive the data through a comparatively low-speed interface such as, but not limited to, a low-voltage differential signaling (LVDS) or a serial peripheral interface (SPI). In an embodiment, the drive part 820 may receive the image data information in the frame unit through the interface operated in a 120 Hertz (Hz) unit and store the same in the memory.

However, if the frame memory 811 is included in the timing controller 810, the timing controller 810 may convert the image data information in the frame unit that is stored in the frame memory 811 into the image data information in the sub-frame unit, and transmit the data in the sub-frame unit to the drive part 820. The interface 821 of the drive part 820, which may need to receive the data in the sub-frame unit, may thus need to be operated at a relatively high speed when compared to receiving the data in the frame unit.

The line memory 822 may be a component for converting the image data information in the sub-frame unit that is input from the timing controller 810 into the image data information in a line unit and store the same. For example, the line memory 822 may store the image data information in the sub-frame unit as the image data information in a scan line unit to be provided to the plurality of micro LEDs 120.

The output buffer 823 may be a component for converting the image data information in the line unit that is provided from the line memory 822 into the image data signal and outputting the same. The signal output through the output buffer 823 may be provided to the plurality of micro LEDs 120.

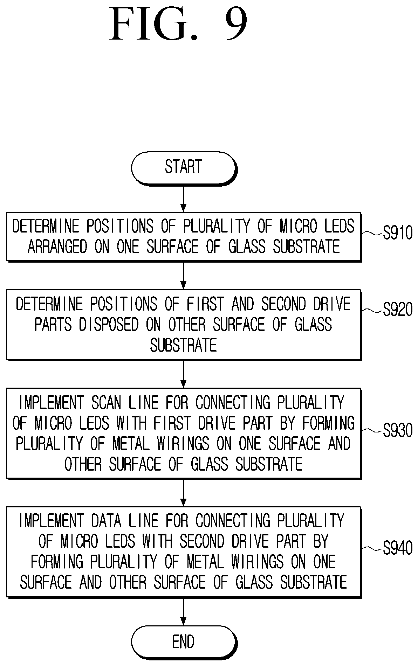

The number and arrangement of components of the drive part 820 shown in FIG. 9 are provided as an example. In practice, there may be additional components, fewer components, different components, or differently arranged components than those shown in FIG. 9. Furthermore, two or more components shown in FIG. 9 may be implemented within a single component, or a single component shown in FIG. 9 may be implemented as multiple, distributed components. Alternatively or additionally, a set of (one or more) components shown in FIG. 9 may be integrated with each other, and/or may be implemented as an integrated circuit, as software, and/or a combination of circuits and software.

FIGS. 9 to 11 are flowcharts illustrating a manufacturing method of a display device, according to the various embodiments of the present disclosure.

Referring to FIG. 9, the method may include determining positions of a plurality of micro light emitting diodes (LEDs) arranged on one surface of a glass substrate (operation S910). In addition, the method may include determining positions of a first drive part and a second drive part, disposed on the other surface of the glass substrate (operation S920). A wiring for implementing a scan line or a data line may be determined based on the positions of the plurality of micro LEDs, the first drive part, and the second drive part, arranged on the glass substrate. In addition, a position of a connection pad may be determined based on the positions of the plurality of micro LEDs, the first drive part, and the second drive part, arranged on the glass substrate.

The method may include implementing the scan line for connecting the plurality of micro LEDs with the first drive part by using a plurality of metal wirings respectively formed on one surface and the other surface of the glass substrate if the positions of the plurality of micro LEDs and the first drive part, arranged on the glass substrate, are determined (operation S930). In an embodiment, the metal wiring formed on one surface of the glass substrate and the metal wiring formed on the other surface of the glass substrate may be connected to each other through a through-glass via (TGV) passing through the glass substrate.

In addition, the method may include implementing the data line for connecting the plurality of micro LEDs with the second drive part by using a plurality of metal wirings respectively formed on one surface and the other surface of the glass substrate if the positions of the plurality of micro LEDs and the second drive part on the glass substrate, arranged on the glass substrate, are determined (operation S940). In an embodiment, the metal wiring formed on one surface of the glass substrate and the metal wiring formed on the other surface of the glass substrate may be connected to each other through the through-glass via (TGV) passing through the glass substrate. The plurality of micro LEDs and the second drive part may have the metal wiring formed for the plurality of micro LEDs to be grouped into the plurality of groups based on the scan line and for each group to be connected to the different data line.

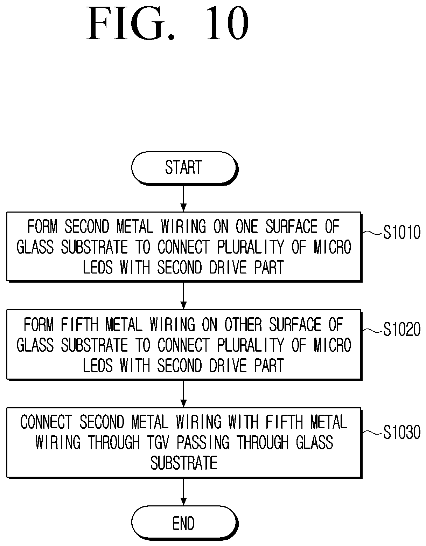

FIG. 10 is a diagram illustrating a method of implementing the data line for connecting the plurality of micro LEDs with the second drive part by forming the plurality of metal wirings on one surface and the other surface of the glass substrate.

Referring to FIG. 10, the method may include forming a second metal wiring on one surface of the glass substrate to connect the plurality of micro LEDs with the second drive part (operation S1010). For example, the second metal wiring may be disposed on one surface of the glass substrate in a vertical direction.

The method may include forming a fifth metal wiring on the other surface of the glass substrate to connect the plurality of micro LEDs with the second drive part (operation S1020). For example, if the plurality of micro LEDs and the second drive part are disposed as shown in FIG. 2 or 3, the second metal wiring for implementing the data line in the vertical direction may be formed on one surface of the glass substrate, and the fifth metal wiring for connecting the second metal wiring with each channel of the second drive part may be formed on the other surface of the glass substrate.

In addition, the method may include connecting the second metal wiring with the fifth metal wiring through the TGV passing through the glass substrate (operation S1030). For example, the second metal wiring formed on one surface of the glass substrate and the fifth metal wiring formed on the other surface of the glass substrate may be electrically connected to each other through the TGV at an intersection where the wirings intersect each other.

In an embodiment, the method may include forming first connection pads disposed on one surface of the glass substrate and respectively electrically connected to the plurality of micro LEDs. The first connection pad may be formed on one surface of the glass substrate by using a first metal layer. The first connection pad may be formed to connect the micro LED with the second drive part. For example, the first connection pad may electrically connect each micro LED with the second metal wiring. In an embodiment, the method may include forming a via between the first metal layer and the second metal wiring to electrically connect each of the first connection pads with the second metal wiring. The via may pass through an insulating layer disposed between the first metal layer and the second metal wiring.

The method may include forming second connection pads disposed on the other surface of the glass substrate and respectively electrically connected to the second drive part. The second connection pad may be formed on the other surface of the glass substrate by using a sixth metal layer. The second connection pad may be formed to electrically connect the second drive part with the fifth metal wiring. In an embodiment, the method may include forming a via between the sixth metal layer and the fifth metal wiring to electrically connect each of the second connection pads with the fifth metal wiring. The via may pass through an insulating layer disposed between the sixth metal layer and the fifth metal wiring. The second connection pad may be electrically connected to the second drive part through a film on glass (FOG) wiring.

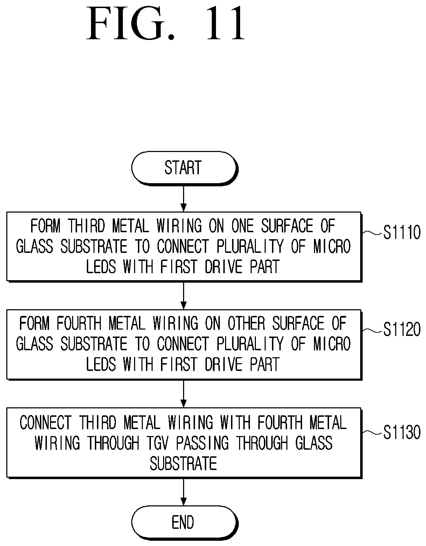

FIG. 11 is a diagram illustrating a method of implementing the scan line for connecting the plurality of micro LEDs with the first drive part by forming the plurality of metal wirings on one surface and the other surface of the glass substrate.

Referring to FIG. 11, the method may include forming a third metal wiring on one surface of the glass substrate to connect the plurality of micro LEDs with the first drive part (operation S1110). For example, the third metal wiring may be disposed on one surface of the glass substrate in a horizontal direction.

The method may include forming a fourth metal wiring on the other surface of the glass substrate to connect the plurality of micro LEDs with the first drive part (operation S1120). For example, if the plurality of micro LEDs and the first drive part are disposed as shown in FIG. 2 or 3, the third metal wiring for implementing the scan line in the horizontal direction may be formed on one surface of the glass substrate, and the fourth metal wiring for connecting the third metal wiring with each scan terminal of the first drive part may be formed on the other surface of the glass substrate.

In addition, the method may include connecting the third metal wiring with the fourth metal wiring through the TGV passing through the glass substrate (operation S1130). The third metal wiring formed on one surface of the glass substrate and the fourth metal wiring formed on the other surface of the glass substrate may be electrically connected to each other through the TGV at an intersection where the wirings intersect each other.

In an embodiment, the method may include forming third connection pads disposed on one surface of the glass substrate and respectively electrically connected to the plurality of micro LEDs. The third connection pad may be formed on one surface of the glass substrate by using the first metal layer. The first connection pad and the third connection pad may be connected to the anode and cathode of each micro LED.

The third connection pad may be formed to connect the micro LED with the first drive part. For example, the third connection pad may electrically connect each micro LED with the third metal wiring. In an embodiment, the method may include forming a via between the third connection pad and the third metal wiring to electrically connect each of the third connection pads with the third metal wiring. The via may pass through an insulating layer disposed between the first metal layer and the third metal wiring. In some embodiments, a second metal pattern may be formed between the first metal layer and the third metal wiring, and a via may pass through an insulating layer disposed between the first metal layer and the second metal pattern and an insulating layer disposed between the second metal pattern and the third metal wiring.

The method may include forming fourth connection pads disposed on the other surface of the glass substrate and respectively electrically connected to the first drive part. The fourth connection pad may be formed on the other surface of the glass substrate by using the sixth metal layer. The fourth connection pad may be formed to electrically connect the first drive part with the fourth metal wiring. In an embodiment, the method may include forming a via between the fourth connection pad and the fourth metal wiring to electrically connect each of the fourth connection pads with the fourth metal wiring. The via may pass through an insulating layer disposed between the sixth metal layer and the fourth metal wiring. The fourth connection pad may be electrically connected to the first drive part through the film on glass (FOG) wiring.

As set forth above, the display device and the manufacturing method thereof, according to the various embodiments of the present disclosure, may form the wiring on the glass substrate by using the low-layer metal layer, thereby potentially reducing the manufacturing cost of the display device and providing for the implementing of a fine pitch display, when compared to a related display device. In addition, in the display device and the manufacturing method thereof, according to the various embodiments of the present disclosure, the plurality of micro LEDs may be grouped into the plurality of groups based on the row line and connected to the different data lines, and the drive part may provide the image data signal based on the grouped data lines, thereby potentially reducing the load of the drive part for driving the plurality of micro LEDs, when compared to related display devices.

According to aspects of the present disclosure, the various embodiments described above may be implemented in software including an instruction stored in a machine-readable storage medium (e.g., a computer-readable storage medium). A machine may be and/or may include a device that may invoke the stored instruction from a storage medium, may be operated based on the invoked instruction, and may include the display device, according to the disclosed embodiments. If the instruction is executed by the processor, the processor may directly perform a function corresponding to the instruction and/or another component may perform the function corresponding to the instruction under the control of the processor. The instruction may include codes generated or executed by a compiler or an interpreter. The machine-readable storage medium may be provided in the form of a non-transitory storage medium. As used herein, the term "non-transitory" only indicates that the storage medium is tangible without including a signal, and does not distinguish whether data are semi-permanently or temporarily stored in the storage medium.

In addition, according to various embodiments of the present disclosure, the method described above may be provided by being included in a computer program product. The computer program product may be traded as a product between a seller and a purchaser. The computer program product may be distributed in a form of the machine-readable storage medium (e.g., a compact disc read only memory (CD-ROM)) or online through an application store (e.g., PlayStore^{™}). In a case of the online distribution, at least a portion of the computer program product may be at least temporarily stored in or temporarily provided to a storage medium such as a memory of a server of a manufacturer, a server of an application store, or a relay server.

In addition, each of the components (e.g., modules or programs), according to the various embodiments described above, may include one entity or a plurality of entities, and some of the corresponding sub-components described above may be omitted or other sub-components may be further included in the various embodiments. Alternatively or additionally, some of the components (e.g., modules or programs) may be integrated into one entity, and may perform functions performed by the respective corresponding components before being integrated in the same or similar manner. Operations performed by the modules, the programs, or other components, according to the various embodiments, may be executed in a sequential manner, a parallel manner, an iterative manner, or a heuristic manner, and at least some of the operations may be performed in a different order or be omitted, or other operations may be added.

Although the embodiments are shown and described in the present disclosure as above, the present disclosure is not limited to the above-mentioned specific embodiments, and may be variously modified by those skilled in the art to which the present disclosure pertains without departing from the scope of the present disclosure as claimed in the accompanying claims. These modifications should also be understood to fall within the scope and spirit of the present disclosure.

## Claims

1. A display device, comprising:
a glass substrate;
a plurality of micro light emitting diodes (LEDs) disposed on a first surface of the glass substrate;
a first drive part disposed on a second surface of the glass substrate and configured to drive the plurality of micro LEDs to emit light in a row-line order; and
a second drive part disposed on the second surface of the glass substrate and configured to provide an image data signal through a data line coupled with one or more micro LEDs from among the plurality of micro LEDs,
wherein the plurality of micro LEDs are grouped into a plurality of groups based on a row line and each group of the plurality of groups is coupled with a different data line,
wherein the one or more micro LEDs belong to a same column line.

2. The display device of claim 1, wherein the data line comprises:
a first metal wiring formed on the first surface of the glass substrate and coupled with the plurality of micro LEDs;
a second metal wiring formed on the second surface of the glass substrate and coupled with the second drive part; and
a through-glass via (TGV) passing through the glass substrate and coupling the first metal wiring with the second metal wiring.

3. The display device of claim 2, further comprising:
a plurality of first connection pads disposed on the first surface of the glass substrate and formed by a first metal layer,
wherein the plurality of first connection pads respectively couple the plurality of micro LEDs with the first metal wiring.

4. The display device of claim 2, further comprising:
a plurality of second connection pads disposed on the second surface of the glass substrate and formed by a second metal layer,
wherein the plurality of second connection pads respectively couple the second drive part with the second metal wiring.

5. The display device of claim 1, further comprising:
a scan line comprising:
a first metal wiring formed on the first surface of the glass substrate and coupled with the plurality of micro LEDs;
a second metal wiring formed on the second surface of the glass substrate and coupled with the first drive part; and
a through-glass via (TGV) passing through the glass substrate to couple the first metal wiring with the second metal wiring,
wherein the first drive part is configured to provide, using the scan line, a scan signal to the plurality of micro LEDs.

6. The display device of claim 5, further comprising:
a plurality of first connection pads disposed on the first surface of the glass substrate and formed by a first metal layer,
wherein the plurality of first connection pads respectively couple the plurality of micro LEDs with the first metal wiring.

7. The display device of claim 5, further comprising:
a plurality of second connection pads disposed on the second surface of the glass substrate and formed by a second metal layer,
wherein the plurality of second connection pads respectively couple the first drive part with the second metal wiring.

8. The display device of claim 1, further comprising:
a timing controller configured to provide a scan signal and the image data signal to the first drive part and the second drive part,
wherein the timing controller comprises:
a frame memory for storing image data information; and
a timing control part configured to:
convert the image data information in a frame unit that is stored in the frame memory into image data information in a sub-frame unit, and
output the converted image data information in the sub-frame unit.

9. The display device of claim 8, wherein the second drive part comprises
an interface configured to receive, from the timing control part, the image data information in the sub-frame unit;
a line memory configured to convert the image data information in the sub-frame unit into image data information in a line unit and to store the converted image data information in the line unit; and
an output buffer configured to convert the image data information in the line unit obtained from the line memory into the image data signal and to output the converted image data signal.

10. A manufacturing method of a display device, the manufacturing method comprising:
determining first positions of a plurality of micro light emitting diodes (LEDs) disposed on a first surface of a glass substrate of the display device;
determining second positions of a first drive part and a second drive part, disposed on a second surface of the glass substrate;
implementing a scan line coupling the plurality of micro LEDs with the first drive part by using a plurality of metal wirings respectively formed on the first surface and the second surface of the glass substrate; and
implementing a data line coupling the plurality of micro LEDs with the second drive part by using the plurality of metal wirings respectively formed on the first surface and the second surface of the glass substrate,
wherein the implementing of the data line comprises coupling the plurality of micro LEDs with the second drive part,
wherein the plurality of micro LEDs are grouped into a plurality of groups based on the scan line,
wherein each group of the plurality of groups is coupled with a different data line.

11. The manufacturing method of claim 10, wherein the implementing of the data line comprises:
forming a first metal wiring on the first surface of the glass substrate from among the plurality of metal wirings to couple the plurality of micro LEDs with the second drive part,
forming a second metal wiring on the second surface of the glass substrate from among the plurality of metal wirings to couple the plurality of micro LEDs with the second drive part, and
coupling the first metal wiring with the second metal wiring through a through-glass via (TGV) passing through the glass substrate.

12. The manufacturing method of claim 11, further comprising:
forming a plurality of first connection pads disposed on the first surface of the glass substrate and respectively coupled to the plurality of micro LEDs; and
forming a via to couple each of the plurality of first connection pads with the first metal wiring.

13. The manufacturing method of claim 11, further comprising:
forming a plurality of second connection pads disposed on the second surface of the glass substrate and respectively coupled with the second drive part; and
forming a via to couple each of the plurality of second connection pads with the second metal wiring.

14. The manufacturing method of claim 10, wherein the implementing of the scan line comprises
forming a first metal wiring on the first surface of the glass substrate from among the plurality of metal wirings to couple the plurality of micro LEDs with the first drive part,
forming a second metal wiring on the second surface of the glass substrate from among the plurality of metal wirings to couple the plurality of micro LEDs with the first drive part, and
coupling the first metal wiring with the second metal wiring through a through-glass via (TGV) passing through the glass substrate.

15. The manufacturing method of claim 14, further comprising:
forming a plurality of third connection pads disposed on the first surface of the glass substrate and respectively coupled with the plurality of micro LEDs;
forming a via to couple each of the plurality of third connection pads with the first metal wiring;
forming a plurality of fourth connection pads disposed on the second surface of the glass substrate and coupled with the first drive part; and
forming a via to couple each of the plurality of fourth connection pads with the second metal wiring.
